# FASCICULE DE BREVET EUROPEEN

(11) **EP 0 820 424 B1**
(45) Date de publication et mention de la délivrance du brevet: **19.07.2000**
(21) Numéro de dépôt: 96913580.5
(22) Date de dépôt: 12.04.1996
(51) Int. Cl.: C04B 35/80, C04B 35/577

(54) **PROCEDE POUR L'INFILTRATION CHIMIQUE EN PHASE VAPEUR D'UN MATERIAU COMPOSE DE CARBONE ET DE SILICIUM ET/OU BORE**
VERFAHREN ZUR CHEMISCHEN DAMPFINFILTRATION EINES AUS KOHLENSTOFF UND SILICIUM UND/ODER BOR ZUSAMMENGESETZTEN MATERIALS
METHOD FOR THE CHEMICAL VAPOUR INFILTRATION OF A MATERIAL CONSISTING OF CARBON AND SILICON AND/OR BORON

(30) Priorité: 12.04.1995 FR 9504381
(43) Date de publication de la demande: 28.01.1998
(73) Titulaire: SOCIETE NATIONALE D'ETUDE ET DE CONSTRUCTION DE MOTEURS D'AVIATION, "S.N.E.C.M.A.", 75015 Paris (FR)
(72) Inventeur: ROBIN-BROSSE, Christian, F-33185 Le Haillan (FR); DELPERIER, Bernard, F-33127 Marignas-sur-Jalles (FR); BONDIEU, Gilles, F-33127 Saint-Jean-d'Illac (FR)
(74) Mandataire: Joly, Jean-Jacques
(86) Numéro de dépôt international: FR9600561
(87) Numéro de publication internationale: WO9632360

(56) Documents cités:
- EP-A- 0 483 009
- WO-A-87/04733

## Description

La présente invention concerne un procédé de densification d'un substrat poreux par un matériau obtenu par infiltration chimique en phase vapeur et composé de carbone ainsi que de silicium et/ou de bore. Un tel matériau peut être du carbure de silicium, du carbure de bore, ainsi que tout système ternaire intermédiaire Si-B-C.

Un domaine particulier d'application de l'invention est la fabrication de pièces en matériau composite par densification d'un substrat fibreux, ou préforme, par une matrice obtenue par infiltration chimique en phase vapeur et constituée au moins en partie par un matériau composé de carbone ainsi que de silicium et/ou de bore.

Des procédés et une installation d'infiltration chimique en phase vapeur, permettant notamment la fabrication de pièces en matériau composite à matrice SiC, sont décrits par exemple dans les documents FR-A-2 401 888, FR-A-2 567 874 et WO 87/04733, tandis que la densification de préformes par une matrice constituée au moins en partie par un système ternaire Si-B-C est décrite dans le document FR-A-2 668 477.

Les préformes fibreuses à densifier sont placées dans la chambre de réaction d'un four d'infiltration. Une phase gazeuse précurseur de la matrice à former est admise dans la chambre, par exemple à la partie supérieure. Le précurseur gazeux de SiC utilisé habituellement est du méthyltrichlorosilane (MTS) additionné d'hydrogène (H₂). Le précurseur gazeux du carbure de bore utilisé habituellement est un mélange de chlorure de bore (BCl₃) et d'un hydrocarbure gazeux ou mélange d'hydrocarbures, par exemple du propane (C₃H₈) et/ou du méthane (CH₄) ou du gaz naturel. Une matrice ou partie de matrice en un système ternaire Si-B-C est obtenue à partir par exemple d'un mélange de MTS et BCl₃, en proportions adéquates, additionné de H₂. Dans des conditions déterminées de température et de pression, la phase gazeuse diffuse au sein de la porosité accessible des préformes, jusqu'au coeur de celles-ci, et réagit pour former le dépôt désiré sur les fibres. Un préchauffage de la phase gazeuse à son entrée de la chambre peut être réalisé, par exemple par passage à travers des plateaux perforés portés à la température régnant dans la chambre. Les gaz résiduels sont extraits par pompage à travers une sortie située à la base de la chambre.

De tels procédés donnent des résultats satisfaisants lorsque le volume effectivement occupé par les préformes dans la chambre de réaction est faible. Il en est ainsi lorsque les préformes requièrent la présence d'outillages de maintien pour conserver leurs formes et ont de faibles épaisseurs ou sont très espacées les unes des autres dans le four. Des exemples de telles préformes sont celles destinées à la fabrication d'éléments de protection thermique épousant la forme de carénage de véhicules spatiaux, ou à la fabrication de volets de réacteurs d'avions. Il est alors en effet courant que le taux de chargement effectif du four, c'est-à-dire le pourcentage du volume de la chambre de réaction réellement occupé par les préformes, soit inférieur à 5 %.

Par contre, les performances de ces procédés connus se dégradent nettement lorsque l'on augmente sensiblement le taux de remplissage des fours. Cette augmentation est possible avec des préformes de géométrie simple, qui ne nécessitent pas d'outillages de maintien, ou des préformes épaisses. Il en est ainsi pour des préformes aiguilletées épaisses destinées à la fabrication de pièces de friction, notamment de disques de freins d'avions en matériau composite à matrice SiC ou Si-B-C, ou au moins partiellement SiC ou Si-B-C. En effet, la forme de ces préformes permet de les empiler et atteindre un taux de chargement supérieur à 25 % voire même supérieur à 30 %. La dégradation constatée dans les performances des procédés d'infiltration connus consiste notamment dans une hétérogénéité très marquée de la densification dans la direction longitudinale, c'est-à-dire dans le sens de l'écoulement de la phase gazeuse depuis son entrée dans la chambre de réaction jusqu'à sa sortie. On observe en effet une densification beaucoup plus rapide et importante des préformes les plus proches de l'entrée de la phase gazeuse en comparaison avec celles qui en sont le plus éloignées.

Un autre inconvénient rencontré est une hétérogénéité marquée de la densification des préformes épaisses, c'est-à-dire l'existence d'un fort gradient de densification entre le coeur des pièces, où l'introduction de la matrice est la moins importante, et les zones des pièces proches de leur surface extérieure, où l'introduction de la phase gazeuse est la plus importante.

Pour des impératifs évidents de rendement des fours d'infiltration et de qualité des pièces produites, il est nécessaire de réduire autant que possible ces hétérogénéités de densification.

L'hétérogénéité de densification longitudinale provient essentiellement d'un appauvrissement de la phase gazeuse au fur et à mesure de sa progression dans la chambre de réaction. Pour y remédier, il peut être envisagé d'augmenter le débit de phase gazeuse admise dans le four. Mais il en résulte une densification encore plus rapide et importante des préformes situées à proximité de l'accès de la phase gazeuse, sans atténuation du gradient de densification au sein des pièces.

Un objet de la présente invention est de fournir un procédé d'infiltration chimique en phase vapeur d'un matériau composé de carbone ainsi que de silicium et/ou de bore permettant d'augmenter le taux de chargement effectif des fours d'infiltration tout en limitant fortement l'hétérogénéité de densification dans les chambres de réaction des fours entre l'entrée de la phase gazeuse et la sortie des gaz résiduels.

Un autre objet de la présente invention est de fournir un procédé d'infiltration chimique en phase vapeur permettant de réduire le gradient de densification au sein de pièces épaisses.

Selon un procédé conforme à l'invention, l'infiltration chimique en phase vapeur au sein d'un substrat poreux est réalisée à une température au plus égale à 1050°C au moyen d'une phase gazeuse contenant un précurseur gazeux du matériau composé de carbone ainsi que de silicium et/ou de bore, et du chlorure d'hydrogène (HCl). Le précurseur gazeux est constitué par un gaz ou un mélange de gaz. La proportion en volume d'HCl par rapport au précurseur gazeux de silicium et/ou de bore est de préférence d'au moins 10 %, par exemple au moins égale à 25 %, le précurseur de silicium étant par exemple du MTS et le précurseur de bore BCl₃.

Il a été constaté que l'introduction de HCl dans la phase gazeuse permet d'éviter un appauvrissement prématuré de celle-ci. En effet, la présence de HCl ralentit la formation de la matrice dans les pièces exposées en premier à la phase gazeuse ayant pénétré dans le four d'infiltration. Il est alors possible d'augmenter le débit de précurseur gazeux et par conséquent le taux de chargement du four sans rencontrer les inconvénients précités.

L'infiltration chimique en phase vapeur peut être réalisée avec gradient de température, c'est-à-dire en chauffant le substrat poreux de sorte qu'il présente une température plus élevée dans des parties éloignées de ses surfaces exposées qu'au niveau de celles-ci.

La formation de la matrice étant favorisée dans les parties du substrat de température plus élevée, l'établissement du gradient thermique permet de combattre l'hétérogénéité de densification au sein du substrat.

Le chauffage du substrat peut être réalisé par contact entre une surface du substrat et un corps chauffé, de sorte qu'un gradient de température s'établit entre la surface du substrat au contact du corps chauffé et les surfaces du substrat exposées au flux gazeux. Le corps chauffé peut être un induit couplé électromagnétiquement à un inducteur.

Lorsque le substrat est en un matériau conducteur de l'électricité, par exemple le carbone, son chauffage peut être réalisé par induction par couplage direct avec un inducteur.

Ces techniques d'infiltration chimique en phase vapeur avec gradient de température sont décrites dans le document FR-A-2 711 647.

Des exemples de mise en oeuvre de procédés conformes à l'invention seront maintenant décrits de façon plus détaillée.

Il sera fait référence aux dessins joints sur lesquels :
- la figure 1 est une vue très schématique d'une installation permettant la mise en oeuvre d'un procédé d'infiltration chimique en phase vapeur d'un matériau composé de carbone ainsi que de silicium et/ou de bore, à température constante, et
- la figure 2 est une vue très schématique d'une installation permettant la mise en oeuvre d'un procédé d'infiltration chimique en phase vapeur d'un matériau composé de carbone ainsi que de silicium et/ou de bore, avec gradient de température.

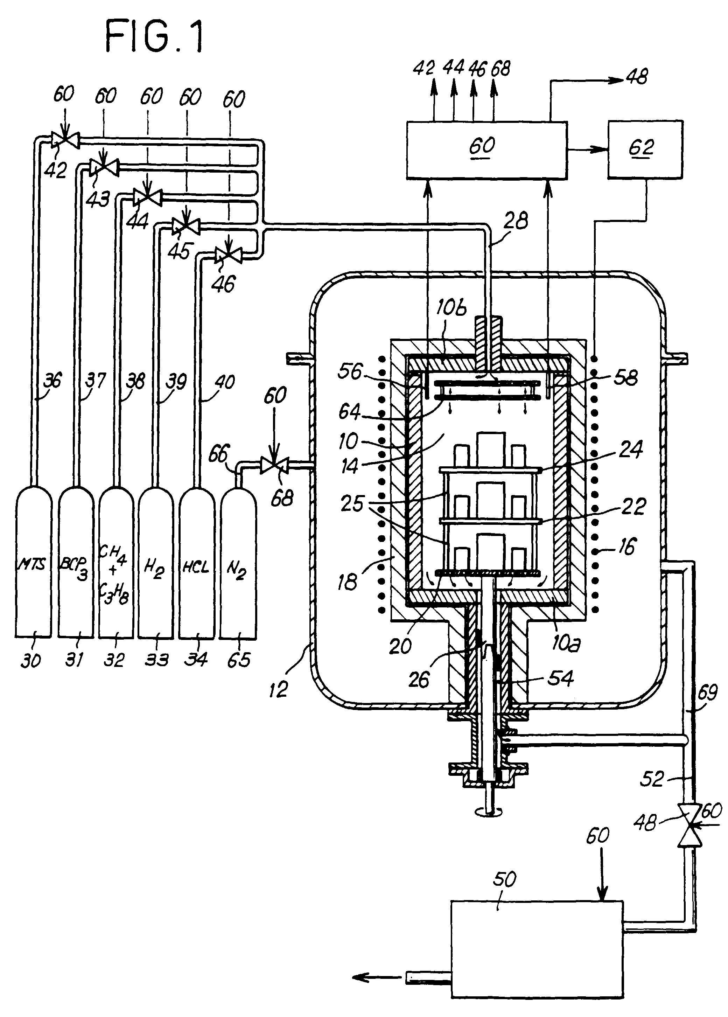

L'installation illustrée par la figure 1 est du type de celle décrite dans le document WO 87/04733 déjà cité.

Un induit en graphite 10 logé à l'intérieur d'une enceinte métallique étanche 12 délimite une chambre de réaction 14. A l'intérieur de l'enceinte 12, l'induit 10 est entouré d'un inducteur métallique 16 avec interposition d'un isolant thermique 18. L'induit 10 est sous forme d'un cylindre d'axe vertical fermé de façon étanche par un fond 10a à sa partie inférieure et un couvercle amovible lOb à sa partie supérieure.

A l'intérieur de la chambre 14, les substrats à densifier sont supportés par un plateau de base 20 pouvant tourner autour d'un axe vertical confondu avec celui de l'induit 10 et de l'inducteur 16. Des plateaux supplémentaires 22, 24, supportés par le plateau 20 avec interposition d'entretoises 25, permettent d'effectuer un chargement des substrats sur plusieurs niveaux, au total trois dans l'exemple illustré. La rotation du plateau de base 20 est commandée au moyen d'un moteur (non représenté) couplé à un arbre 26 traversant la paroi inférieure de l'enceinte 12 et le fond 10a de l'induit et fixé au plateau 20 à la face inférieure de celui-ci.

La phase gazeuse propre à former le matériau de la matrice destinée à densifier les substrats est admise par une canalisation 28 qui aboutit à la partie supérieure de la chambre 14 à travers le couvercle 10b. La phase gazeuse comprend un mélange d'un précurseur gazeux du matériau de la matrice et de HCl. Le précurseur gazeux dépend de la nature de la matrice. Pour une matrice SiC, le précurseur gazeux est du MTS additionné de H₂. Pour une matrice en carbure de bore, le précurseur gazeux est un mélange de BCl₃ et d'un précurseur de carbone. Ce dernier peut être un alcane, un alkyle ou un alcène, seul ou en mélange, par exemple un mélange de C₃H₈ et de CH₄ (ou de gaz naturel). Pour une matrice constituée d'un système ternaire Si-B-C, le précurseur gazeux est un mélange de MTS et BCl₃ additionné de H₂. Les gaz MTS, BCl₃, C₃H₈ + CH₄, H₂ et HCl sont issus de sources 30, 31, 32, 33, 34 à travers des conduites d'alimentation 36, 37, 38, 39, 40 munies de vannes d'injection 42, 43, 44, 45, 46 et aboutissant à la canalisation 28.

L'extraction des gaz résiduels hors de la chambre 14 est réalisée par ouverture d'une vanne 48 qui met la chambre 14 en communication avec un dispositif de pompage 50 à travers au moins une canalisation d'évacuation 52. Le dispositif de pompage 50 est par exemple une pompe à anneau d'eau. La canalisation 52 communique avec la partie inférieure de la chambre 14 à travers un passage annulaire 54 formé autour de l'arbre 26.

Des signaux produits par des capteurs de pression 56 et de température 58, représentant la pression et la température dans la chambre 14, sont transmis à un automate 60. Celui-ci commande la pompe 50 et la vanne 48 pour établir la pression voulue dans la chambre 14 avant admission de la phase gazeuse et commande un générateur 62 alimentant l'inducteur 16 afin de maintenir la température dans l'enceinte à la valeur désirée. L'automate 60 commande en outre les vannes 42, 43, 44, 45, 46 pour régler les débits respectifs de MTS, BCl₃, CH₄ + C₃H₈, H₂ et HCl en fonction de la composition prédéterminée de la phase gazeuse.

La phase gazeuse pénétrant dans la chambre de réaction 14 parvient tout d'abord au contact de plateaux de préchauffage 64, par exemple sous forme de plaques perforées superposées. Les plateaux de préchauffage étant à l'intérieur de la chambre de réaction, ils sont en permanence à la température régnant dans celle-ci. Cela permet de porter la phase gazeuse à la température voulue avant contact avec les substrats à densifier.

Le volume situé autour de l'induit 10 à l'intérieur de l'enceinte peut être balayé en permanence par un gaz neutre, tel que de l'azote (N₂). Celui-ci provient d'une source de gaz 65 à travers une conduite 66 munie d'une vanne 68 commandée par l'automate 60. L'azote forme ainsi un tampon de gaz neutre autour de la chambre de réaction. Il est extrait à travers une conduite 69 qui aboutit à la conduite d'évacuation 52 à l'extérieur de l'enceinte 12.

Des essais d'infiltration chimique en phase vapeur par une matrice SiC ont été effectués avec l'installation décrite ci-avant. Lors de chaque essai, a été disposé à chacun des trois niveaux de chargement du four un même ensemble de substrats poreux constitué par :
- un échantillon cylindrique A d'une texture en fibres de carbone aiguilletée de diamètre 90 mm et épaisseur 35 mm,
- trois échantillons cylindriques B de diamètre 35 mm et hauteur 35 mm de la même texture,
- un échantillon cylindrique C de diamètre 15 mm et hauteur 35 mm de la même texture,
- un échantillon cylindrique D de diamètre 15 mm et hauteur 8 mm de la même texture, et
- un échantillon cubique E d'environ 2 cm³ d'un substrat en fibres de carbone partiellement densifié par aspiration de poudre sous vide,

La texture des échantillons A, B, C et D est réalisée par empilage et aiguilletage progressif de nappes bidirectionnelles en fibres de carbone, comme décrit dans le document FR-A-2 584 106. Cette texture est identique à celle constituant des préformes pour des disques de frein en matériau composite carbone-carbone équipant des avions de type "Airbus".

Le substrat de l'échantillon E est constitué par un feutre de fibres de carbone partiellement densifié par aspiration sous vide de poudre de carbone, comme décrit dans le document FR-A-2 671 797.

Chacun des essais a été effectué avec une pression (P) dans la chambre de réaction de 10 kPa, avec un rapport entre les débits de H₂(Q(H₂)) et de MTS (Q(MTS)) égal à 6 et pendant une durée totale (d) de 20 h.

Une première série de trois essais I, II, III a été effectuée avec une température T dans la chambre de réaction de 1010°C, un Q(MTS) égal à 150 sccm (standard cm³/min.) et un Q(H₂) égal à 900 sccm, en donnant au débit de HCl(Q(HCl)) des valeurs de 0, 37,5 et 75 sccm respectivement, c'est-à-dire des proportions égales successivement à 0, 25 et 50 % entre les débits de HCl et de MTS.

Un quatrième essai IV a été effectué en doublant les Q(MTS) et Q(H₂) par rapport à l'essai III, les autres paramètres étant inchangés.

Un cinquième essai V a été effectué dans les mêmes conditions que l'essai IV, à l'exception de la température T ramenée de 1010°C à 950°C.

Un sixième essai VI a été effectué dans les mêmes conditions que l'essai V, à l'exception du débit Q(HCl) doublé de 75 sccm à 150 sccm.

Afin de caractériser les performances obtenues quant à la densification des substrats par SiC, les caractéristiques suivantes ont été évaluées :
- le gain de masse relatif Δm/m de chaque substrat, Δm étant la différence entre la masse m' du substrat à la fin de l'essai (après densification) et la masse initiale m du substrat,
- l'hétérogénéité de densification longitudinale (entre l'entrée et la sortie des gaz), c'est-à-dire la variation de la densification en fonction de l'emplacement des substrats dans la chambre de réaction, évaluée en mesurant, pour chaque type de substrat, le rapport entre le gain de masse Δm/m au niveau "haut" (le plus proche de l'entrée de la phase gazeuse) et le gain de masse Δm/m au niveau "bas" (le plus éloigné de l'entrée de la phase gazeuse),
- l'hétérogénéité d'infiltration, c'est-à-dire le gradient de densification entre le coeur et la surface des substrats, évaluée en mesurant, aux différents niveaux "haut", "moyen" et "bas" de la chambre de réaction, le rapport entre la prise de masse Δm/m du substrat A de plus grand volume et la prise de masse Δm/m de celui C de plus petit volume parmi les substrats A, B, C de mêmes nature et hauteur,
- l'épaisseur de dépôt SiC sur les fibres, évaluée par diffraction laser, la précision étant de l'ordre de 0,1 µ,
- le rendement de densification, évalué en calculant le rapport entre la prise de masse effective des substrats et la prise de masse totale théorique possible fonction de la quantité de MTS consommée.

Les résultats obtenus sont regroupés dans les tableaux I à IV ci-après.

**Tableau I**

| Gain de masse | | | | | | | | |
|---|---|---|---|---|---|---|---|---|
| Conditions opératoires | P(kPa) | | 10 | 10 | 10 | 10 | 10 | 10 |
| | d(h) | | 20 | 20 | 20 | 20 | 20 | 20 |
| | T(°C) | | 1010 | 1010 | 1010 | 1010 | 950 | 950 |
| | Q(MTS) | sccm | 150 | 150 | 150 | 300 | 300 | 300 |
| | Q(H₂) | sccm | 900 | 900 | 900 | 1800 | 1800 | 1800 |
| | Q(HCl) | sccm | 0 | 37,5 | 75 | 75 | 75 | 150 |
| Δm/m (%) substrats | | H | 33,1 | 31,1 | 22,8 | 57,3 | 36,2 | 32,3 |
| | A | M | 17,5 | 10,1 | 3,8 | 33,8 | 20,6 | 23,6 |
| | | B | 1,8 | 0,6 | 0,7 | 15,7 | 10,9 | 12,5 |
| | | H | 72,4 | 76 | 68,9 | 137 | 89 | 56,8 |
| | B | M | 27,1 | 25,8 | 16,6 | 54,7 | 34,1 | 33,4 |
| | | B | 4,4 | 0,9 | 1,3 | 32,2 | 20,2 | 21,1 |
| | | H | 113 | 110 | 111 | 208 | 134 | 68,6 |
| | C | M | 29,6 | 18,3 | 9,4 | 52,5 | 25 | 26,2 |
| | | B | 2,7 | 0,9 | 1,2 | 32,8 | 15,9 | 18,8 |
| | | H | 231 | 106,5 | 106 | 313 | 196 | 91,8 |
| | D | M | 29,6 | 18,3 | 4,1 | 123 | 107,3 | 86,6 |
| | | B | 2,7 | 0,8 | 1,9 | 24,5 | 67,7 | 61 |
| | | H | 10,9 | 10,1 | 7,8 | 11,2 | 10 | 9,9 |
| | E | M | 1,4 | 0,9 | 1,7 | 6 | 10 | 8,5 |
| | | B | 0,2 | 1 | 1,4 | 0,5 | 6,8 | 7,5 |

Les lettres H, M, B identifient les niveaux "haut", "moyen" et "bas" dans la chambre de réaction.

A l'évidence, les cycles effectués en doublant les débits de MTS et de H₂ donnent les prises de masse les plus importantes. Les densificaticns les plus homogènes sont celles effectuées à la température la moins élevée (950°C), en particulier en présence de HCl.

**Tableau II**

| Hétérogénéité longitudinale | | | | | | | | |
|---|---|---|---|---|---|---|---|---|
| Conditions opératoires | P(kPa) | | 10 | 10 | 10 | 10 | 10 | 10 |
| | d(h) | | 20 | 20 | 20 | 20 | 20 | 20 |
| | T(°C) | | 1010 | 1010 | 1010 | 1010 | 950 | 950 |
| | Q(MTS) | sccm | 150 | 150 | 150 | 300 | 300 | 300 |
| | Q(H₂) | sccm | 900 | 900 | 900 | 1800 | 1800 | 1800 |
| | Q(HCl) | sccm | 0 | 37,5 | 75 | 75 | 75 | 150 |
| Substrats | A | | 18,4 | 51,8 | 32,6 | 3,6 | 3,3 | 2,6 |
| | B | | 16,5 | 84,4 | 53 | 4,3 | 4,4 | 2,7 |
| | C | | 41,9 | 122,2 | 92,5 | 6,3 | 8,4 | 3,6 |
| | D | | 85,6 | 133,1 | 55,8 | 12,8 | 2,9 | 1,5 |
| | E | | 54,5 | 10,1 | 5,6 | 22,4 | 1,5 | 1,3 |

Les résultats se rapprochent le plus de la valeur optimale théorique (1) pour le cycle effectué avec débits doublés de MTS et H₂, à plus basse température et en présence de HCl.

**Tableau III**

| Hétérogénéité de densification | | | | | | | | |
|---|---|---|---|---|---|---|---|---|
| Conditions opératoires | P(kPa) | | 10 | 10 | 10 | 10 | 10 | 10 |
| | d(h) | | 20 | 20 | 20 | 20 | 20 | 20 |
| | T(°C) | | 1010 | 1010 | 1010 | 1010 | 950 | 950 |
| | Q(MTS) | sccm | 150 | 150 | 150 | 300 | 300 | 300 |
| | Q(H₂) | sccm | 900 | 900 | 900 | 1800 | 1800 | 1800 |
| | Q(HCl) | sccm | 0 | 37,5 | 75 | 75 | 75 | 150 |
| Niveau | H | | 0,29 | 0,28 | 0,21 | 0,28 | 0,27 | 0,47 |
| | M | | 0,59 | 0,56 | 0,41 | 0,64 | 0,82 | 0,9 |
| | B | | 0,66 | 0,67 | 0,58 | 0,48 | 0,68 | 0,66 |

Comme précédemment, les meilleurs résultats sont obtenus avec le cycle à doubles débits MTS et H₂, basse température et présence de HCl.

**Tableau IV**

| Rendement | | | | | | | |
|---|---|---|---|---|---|---|---|
| Conditions opératoires | P(kPa) | 10 | 10 | 10 | 10 | 10 | 10 |
| | d(h) | 20 | 20 | 20 | 20 | 20 | 20 |
| | T(°C) | 1010 | 1010 | 1010 | 1010 | 950 | 950 |
| | Q(MTS) | 150 | 150 | 150 | 150 | 300 | 300 |
| | Q(H₂) sccm | 900 | 900 | 900 | 1800 | 1800 | 1800 |
| | Q(HCl) | 0 | 37,5 | 75 | 75 | 75 | 150 |
| Niveau | H | 28,1 | 26,5 | 23,3 | 22,9 | 17 | 13 |
| | M | 13 | 8,7 | 4,7 | 11,5 | 8 | 9 |
| | B | 1,6 | 0,5 | 0,1 | 5,8 | 4,4 | 5,1 |
| | Total | 42,7 | 35,7 | 28,1 | 40,2 | 29,4 | 27,1 |

Dans le cas des cycles à doubles débits de MTS et H₂ et basse température (950°), la présence de HCl entraîne une diminution du rendement, mais celui-ci est mieux réparti dans l'ensemble du chargement du four et, ce qui est également important au plan industriel, les dépôts parasites sur les plateaux de préchauffage sont quasi absents.

Les résultats regroupés dans les tableaux qui précèdent montrent de façon indiscutable l'intérêt, pour réduire l'hétérogénéité de la densification SiC tant dans le volume du four qu'au sein d'une même pièce, d'effectuer l'infiltration chimique en phase vapeur à température relativement basse, de préférence inférieure à 1000°C en présence de HCl et en augmentant le débit de MTS.

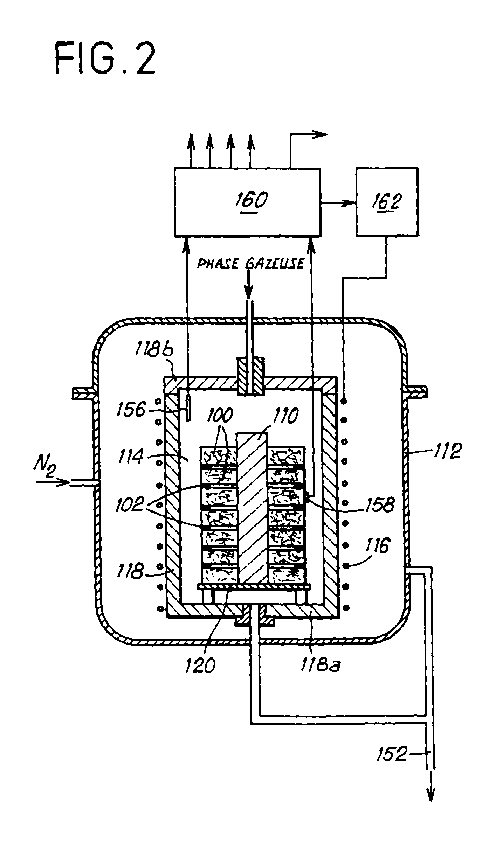

Le processus d'infiltration chimique en phase vapeur du SiC peut être mis en oeuvre avec gradient de température, par exemple au moyen d'une installation telle que montrée schématiquement sur la figure 2.

Cette installation est plus particulièrement destinée à la densification de préformes annulaires 100, telles que des préformes de disques de frein réalisées en un matériau conducteur de la chaleur, tel que le carbone sous forme de fibres. Les préformes sont empilées autour d'un noyau cylindrique central en graphite 110 formant induit, l'ensemble étant supporté par un plateau isolant fixe 120. Les préformes 100 peuvent être légèrement espacées les unes des autres au moyen d'entretoises 102 afin de faciliter l'accès de la phase gazeuse aux faces principales des préformes. La chambre de réaction 114 dans laquelle sont logés l'induit et les préformes à densifier est délimitée par une paroi isolante 118, non conductrice de l'électricité, avec un fond 118a et un couvercle 118b. Un inducteur 116 entoure la paroi 118, le tout étant à l'intérieur d'une enceinte 112.

Les moyens d'alimentation de la chambre 114 par la phase gazeuse MTS + H₂ + HCl et d'extraction des gaz résiduels sont semblables à ceux de l'installation de la figure 1 et ne sont pas représentés. On notera toutefois que la canalisation d'évacuation 152 aboutit directement à la partie inférieure de la chambre 114 à travers le fond 118a. En outre, la chambre 114 n'est pas munie de moyens de préchauffage de la phase gazeuse entrante.

L'induit 110 est chauffé par couplage électromagnétique avec l'inducteur 116. Le chauffage des préformes annulaires est réalisé par contact de leurs surfaces cylindriques internes avec l'induit 110. Il s'établit alors un gradient thermique entre ces surfaces internes et leurs surfaces extérieures exposées, celles-ci étant refroidies par radiation et convection au contact de la phase gazeuse ayant pénétré dans la chambre. Ce gradient dépend notamment des caractéristiques dimensionnelle et de conductivité thermique des préformes. Le générateur 162 alimentant l'inducteur 116 est commandé de sorte que, au moins au début du processus d'infiltration, la température des parties des préformes adjacentes à l'induit soient à une température bien supérieure à la température minimale de dépôt de SiC, c'est-à-airc environ 700°C. La densification SiC se fait donc préférentiellement dans ces parties des préformes. On évite ainsi une densification trop rapide des parties des préformes proches de leurs surfaces extérieures qui pourrait amener un colmatage prématuré de la porosité, empêchant la densification à coeur et engendrant un fort gradient de densification au sein des pièces obtenues.

Le concept d'infiltration chimique en phase vapeur avec gradient de température est connu. Il trouve ici une application particulièrement intéressante du fait de la présence de HCl dans la phase gazeuse, présence ayant notamment un effet bénéfique pour l'homogénéité de la matrice.

Dans l'installation de la figure 2, les substrats 100 sont chauffés par l'intermédiaire de l'induit 110 avec lequel ils sont en contact. Lorsque la nature conductrice des substrats le permet (par exemple des substrats carbone ou graphite avec un taux de fibres relativement élevé), un chauffage des substrats au moins partiellement par couplage direct avec l'inducteur est envisageable, auquel cas l'induit peut éventuellement être omis. Bien que les courants induits s'établissent plutôt au voisinage de la surface des substrats, il s'établit le gradient thermique souhaité du fait du refroidissement des surfaces exposées des substrats par radiation et convection.

Le procédé conforme à l'invention convient pour l'infiltration chimique en phase vapeur d'un matériau composé de carbone ainsi que de silicium et/ou de bore dans tout type de substrat capable de supporter les conditions opératoires et chimiquement compatibles avec la phase gazeuse. Le procédé peut être utilisé pour réaliser une densification par une matrice constituée exclusivement ou partiellement de ce matériau. Dans ce dernier cas, la matrice peut être complétée par une ou plusieurs phases de matrice constituées d'autres matériaux déposés avant et/ou après le matériau composé de carbone ainsi que de silicium et/ou de bore.

## Revendications

1. Procédé pour l'infiltration chimique en phase vapeur d'un matériau composé de carbone ainsi que de silicium et/ou de bore au sein d'un substrat poreux au moyen d'une phase gazeuse contenant un précurseur gazeux dudit matériau,
caractérisé en ce que l'infiltration est réalisée à une température au plus égale à 1050°C et la phase gazeuse contient en outre du chlorure d'hydrogène (HCl).

2. Procédé selon la revendication 1, caractérisé en ce que la proportion en volume de HCl par rapport au précurseur gazeux du silicium et/ou du bore dans la phase gazeuse est au moins égale à 25 %.

3. Procédé selon l'une quelconque des revendications 1 et 2, caractérisé en ce que l'infiltration chimique en phase vapeur est réalisée à une température inférieure à 1000°C.

4. Procédé selon l'une quelconque des revendications 1 à 3, caractérisé en ce que le précurseur gazeux comprend du méthyltrichlorosilane (MTS).

5. Procédé selon la revendication 4, caractérisé en ce que le précurseur gazeux comprend en outre un précurseur de bore.

6. Procédé selon l'une quelconque des revendications 4 et 5, caractérisé en ce que la phase gazeuse comprend en outre de l'hydrogène (H₂).

7. Procédé selon l'une quelconque des revendications 1 à 6, caractérisé en ce que le précurseur gazeux comprend un précurseur de bore et un précurseur de carbone.

8. Procédé selon l'une quelconque des revendications 1 à 7, caractérisé en ce que l'on établit un gradient de température au sein du substrat de sorte qu'il présente une température plus élevée dans des parties éloignées de ses surfaces exposées qu'au niveau de celles-ci.

9. Procédé selon la revendication 8, pour la densification de substrats de forme annulaire, caractérisé en ce que le substrat est disposé autour d'un induit avec lequel il est en contact, le chauffage du substrat étant réalisé par le contact avec l'induit chauffé par couplage avec un inducteur.

10. Procédé selon la revendication 8, caractérisé en ce que le substrat est en une matière conductrice et est chauffé par induction au moins partiellement par couplage direct avec un inducteur.

11. Procédé selon l'une quelconque des revendications 1 à 10, caractérisé en ce que l'on réalise une infiltration chimique en phase vapeur simultanément au sein de plusieurs substrats disposés à l'intérieur d'une chambre de réaction entre une entrée pour la phase gazeuse dans la chambre et une sortie de gaz résiduels hors de la chambre.

12. Procédé selon la revendication 11, caractérisé en ce que l'écoulement de la phase gazeuse dans la chambre est réalisé suivant une direction sensiblement verticale et les substrats sont disposés sur différents plateaux espacés verticalement.

13. Procédé selon la revendication 11, caractérisé en ce que l'écoulement de phase gazeuse dans la chambre est réalisé suivant une direction sensiblement verticale et les substrats sont disposés en pile.

14. Procédé selon la revendication 13, pour la densification de substrats de forme annulaire, caractérisé en ce que les substrats sont disposés en pile autour d'un induit commun avec lequel ils sont en contact, le chauffage des substrats étant réalisé par le contact avec l'induit chauffé par couplage avec un inducteur.

## Claims

1. A method of chemically infiltrating vapor of a material comprising carbon together with silicon and/or boron within a porous substrate by means of a gas containing a gaseous precursor for said material,
characterised in that infiltration is performed at a temperature not greater than 1050°C and the gas further includes hydrogen chloride (HCI).

2. A method according to claim 1, characterised in that the volume proportion of HCI relative to the gaseous precursor for the silicon and/or the boron in the gas is not less than 25%.

3. A method according to claim 1 or 2, characterised in that the chemical vapor infiltration is performed at a temperature of less than 1000°C.

4. A method according to any one of claims 1 to 3, characterised in that the gaseous precursor comprises methyltrichlorosilane (MTS).

5. A method according to claim 4, characterised in that the gaseous precursor further comprises a precursor for boron.

6. A method according to claim 4 or 5, characterised in that the gas further comprises hydrogen (H₂).

7. A method according to any one of claims 1 to 6, characterised in that the gaseous precursor comprises a precursor for boron and a precursor for carbon.

8. A method according to any one of claims 1 to 7, characterised in that a temperature gradient is established within the substrate so that its portions remote from its exposed surfaces present a temperature higher than that of said surfaces.

9. A method according to claim 8, for densifying substrates of annular shape, characterised in that the substrate is placed around a heater core with which it is in contact, the substrate being heated by contact with the core itself heated by coupling with an inductor.

10. A method according to claim 8, characterised in that the substrate is made of a conductive material and is heated by induction, at least partially, by direct coupling with an inductor.

11. A method according to any one of claims 1 to 10, characterised in that a chemical vapor infiltration is performed simultaneously within a plurality of substrates arranged inside a reaction chamber between a gas inlet inside the chamber and a residual gas outlet outside the chamber.

12. A method according to claim 11, characterised in that the flow of the gas into the chamber is performed in a substantially vertical direction and the substrates are arranged over various vertically spaced apart plates.

13. A method according to claim 11, characterised in that the flow of the gas into the chamber is performed in a substantially vertical direction and the substrates are stacked.

14. A method according to claim 13, for densifying substrates of annular shape, characterised in that the substrates are stacked around a common heater core with which they are in contact, the substrate being heated by contact with the core itself heated by coupling with an inductor.

## Patentansprüche

1. Verfahren zur chemischen Infiltration in der Dampfphase eines Materials, das aus Kohlenstoff sowie aus Silizium und/oder aus Bor besteht, ins Innere eines porösen Substrats mittels einer einen gasförmigen Vorläufer des Materials enthaltenden Gasphase,
**dadurch gekennzeichnet,**
daß die Infiltration bei einer Temperatur von höchstens gleich 1.050°C durchgeführt wird und die Gasphase außerdem Chlorwasserstoff (HCl) enthält.

2. Verfahren nach Anspruch 1,
**dadurch gekennzeichnet,**
daß der Volumenanteil von HCl bezogen auf den gasförmigen Vorläufer des Siliziums und/oder des Bors in der Gasphase mindestens gleich 25 % ist.

3. Verfahren nach Anspruch 1 oder 2,
**dadurch gekennzeichnet,**
daß die chemische Infiltration in der Dampfphase bei einer Temperatur unterhalb von 1.000°C durchgeführt wird.

4. Verfahren nach einem der Ansprüche 1 bis 3,
**dadurch gekennzeichnet,**
daß der gasförmige Vorläufer Methyltrichlorsilan (MTS) enthält.

5. Verfahren nach Anspruch 4,
**dadurch gekennzeichnet,**
daß der gasförmige Vorläufer außerdem einen Vorläufer von Bor enthält.

6. Verfahren nach Anspruch 4 oder 5,
**dadurch gekennzeichnet,**
daß die Gasphase außerdem Wasserstoff (H₂) enthält.

7. Verfahren nach einem der Ansprüche 1 bis 6,
**dadurch gekennzeichnet,**
daß der gasförmige Vorläufer einen Vorläufer von Bor und einen Vorläufer von Kohlenstoff enthält.

8. Verfahren nach einem der Ansprüche 1 bis 7,
**dadurch gekennzeichnet,**
daß im Inneren des Substrats ein Temperaturgradient dergestalt hergestellt wird, daß es in den von seinen exponierten Oberflächen entfernten Bereichen eine höhere Temperatur aufweist als an diesen Oberflächen.

9. Verfahren nach Anspruch 8 zur Verdichtung von ringförmigen Substraten,
**dadurch gekennzeichnet,**
daß das Substrat um ein Induktionselement herum, mit dem es in Berührung ist, angeordnet wird, wobei das Erwärmen des Substrats verwirklicht wird durch die Berührung mit dem durch Kopplung mit einem Induktor erwärmten Induktionselement.

10. Verfahren nach Anspruch 8,
**dadurch gekennzeichnet,**
daß das Substrat aus einem leitfähigen Material besteht und zumindest teilweise durch Induktion mittels direkter Kopplung mit einem Induktor erwärmt wird.

11. Verfahren nach einem der Ansprüche 1 bis 10,
**dadurch gekennzeichnet,**
daß gleichzeitig eine chemische Infiltration in der Dampfphase ins Innere mehrerer Substrate, die im Inneren einer Reaktionskammer zwischen einem Einlaß für die Gasphase in die Kammer und einem Auslaß für Restgas aus der Kammer heraus angeordnet sind, durchgeführt wird.

12. Verfahren nach Anspruch 11,
**dadurch gekennzeichnet,**
daß das Strömen der Gasphase in der Kammer in einer genau vertikalen Richtung erfolgt, und die Substrate auf verschiedenen, vertikal beabstandeten Ebenen angeordnet sind.

13. Verfahren nach Anspruch 11,
**dadurch gekennzeichnet,**
daß das Strömen der Gasphase in der Kammer in einer genau vertikalen Richtung erfolgt und die Substrate stapelförmig angeordnet sind.

14. Verfahren nach Anspruch 13 zur Verdichtung von ringförmigen Substraten,
**dadurch gekennzeichnet,**
daß die Substrate stapelförmig um ein gemeinsames Induktionselement herum, mit dem sie in Berührung sind, angeordnet werden, wobei das Erwärmen der Substrate durch die Berührung mit dem mittels Kopplung mit einem Induktor erwärmten Induktionselement verwirklicht wird.
